# EUROPEAN PATENT APPLICATION

(11) **EP 4 730 316 A1**
(43) Date of publication of application: **22.04.2026**
(21) Application number: 25201063.2
(22) Date of filing: 09.09.2025
(51) Int. Cl.: G09G 3/3266

(54) **GATE DRIVER AND ELECTRONIC APPARATUS INCLUDING THE SAME**

(30) Priority: 21.10.2024 KR 20240143661
(71) Applicant: Samsung Display Co., Ltd., Yongin-si, Gyeonggi-do 17113 (KR)
(72) Inventor: Ock, Soojo, Yongin-si, Gyeonggi-do (KR); Hyun, Chaehan, Yongin-si, Gyeonggi-do (KR); Song, Hyungjin, Yongin-si, Gyeonggi-do (KR)
(74) Representative: Gulde & Partner

(57) **Abstract**

In a gate driver including a k^{th} stage and a k+1^{th} stage, each of the k^{th} stage and the k+1^{th} stage includes a logic circuit which controls a signal of a first control node and a signal of a second control node based on an input signal, a first clock signal, and a second clock signal having a phase shifted from the first clock signal, and an output circuit which outputs a third clock signal or a low gate voltage as an output signal based on the signal of the first control node and the signal of the second control node. The third clock signal has the same phase as the first clock signal, while a line, which transmits the third clock signal, is electrically separated from a line, which transmits the first clock signal.

## Description

### BACKGROUND

### 1. Field

Embodiments relate to a display device. More particularly, embodiments relate to a display device that displays an image, a gate driver included in the display device, and an electronic apparatus including the display device.

### 2. Description of the Related Art

A display device may include a display panel, gate drivers, and a data driver. The display panel may include pixels. The gate drivers may provide gate signals to the pixel. The data driver may provide a data voltage to the pixel.

The pixel may include a light-emitting element, a driving transistor, and a plurality of switching transistors. The switching transistors may be turned on in response to the gate signals. The driving transistor may generate a driving current corresponding to the data voltage based on operations of the switching transistors. The light-emitting element may emit light with a luminance corresponding to the driving current.

### SUMMARY

Embodiments provide a gate driver with improved reliability.

Embodiments provide a display device with improved image quality and an electronic apparatus including the display device.

In a gate driver for a display device, the gate driver including a k^{th} stage and a k+1^{th} stage according to embodiments, where k is a natural number greater than or equal to 1, each of the k^{th} stage and the k+1^{th} stage includes a logic circuit which controls a signal of a first control node and a signal of a second control node based on an input signal, a first clock signal, and a second clock signal having a phase shifted from the first clock signal, and an output circuit which outputs a third clock signal or a low gate voltage as an output signal based on the signal of the first control node and the signal of the second control node. The third clock signal has the same phase as the first clock signal, while a line, which transmits the third clock signal, is electrically separated from a line, which transmits the first clock signal.

In an embodiment, the third clock signal provided to the k+1^{th} stage may have the same phase as the second clock signal provided to the k^{th} stage, while a line, which transmits the second clock signal provided to the k^{th} stage, is electrically separated from a line, which transmits the second clock signal provided to the k^{th} stage.

In an embodiment, a line, which transmits the first clock signal provided to the k+1^{th} stage may be electrically connected to a line, which transmits the second clock signal provided to the k^{th} stage.

In an embodiment, the second clock signal may have a phase shifted from the first clock signal by a 1/4 cycle of the first clock signal.

In an embodiment, the first to third clock signals provided to the k+1^{th} stage may have phases shifted from the first to third clock signals provided to the k^{th} stage, respectively.

In an embodiment, each of the first clock signal and the second clock signal may include a high voltage level and a low voltage level, and during a period of the high voltage level, a rising ripple and a falling ripple may occur.

In an embodiment, the third clock signal may not include the rising ripple and the falling ripple.

In an embodiment, the logic circuit may include a first transistor which transmits the input signal to the second control node in response to the first clock signal, a second transistor which transmits the second clock signal to a first node in response to the signal of the second control node, a third transistor which transmits the low gate voltage to a second node in response to the first clock signal, a fourth transistor connected between the second node and a third node and always turned on, a fifth transistor which transmits the first clock signal to the second node in response to the signal of the second control node, sixth and seventh transistors which transmits the second clock signal to a fourth node in response to a signal of the third node and which are connected in series, an eighth transistor which transmits a signal of the fourth node to the first control node in response to the second clock signal, a first capacitor connected between a line which transmits the first clock signal and the first control node, a second capacitor connected between the third node and the fourth node, and a third capacitor connected between the first node and a gate of the second transistor.

In an embodiment, the output circuit may include a ninth transistor which outputs the third clock signal as the output signal in response to the signal of the first control node, and a tenth transistor which outputs the low gate voltage as the output signal in response to the signal of the second control node.

In an embodiment, the logic circuit may further include an eleventh transistor connected between the second control node and a gate of the tenth transistor and always turned on, a twelfth transistor which transmits the first clock signal to the second control node in response to a reset signal, a thirteenth transistor which transmits the low gate voltage to the first control node in response to the reset signal, and a fourteenth transistor which transmits the first clock signal to the first control node in response to the signal of the second control node.

In a gate driver including a k^{th} stage and a k+1^{th} stage according to embodiments, where k is a natural number greater than or equal to 1, each of the k^{th} stage and the k+1^{th} stage includes a logic circuit which controls a signal of a first control node and a signal of a second control node based on an input signal, a first clock signal, and a second clock signal having a phase shifted from the first clock signal, and an output circuit which outputs the first clock signal or a low gate voltage as an output signal based on the signal of the first control node and the signal of the second control node. The first clock signal provided to the k+1^{th} stage has the same phase as the second clock signal provided to the k^{th} stage, while a line, which transmits the first clock signal provided to the k+1^{th} stage is electrically separated from a line, which transmits the second clock signal provided to the k^{th} stage.

In an embodiment, the second clock signal may have a phase shifted from the first clock signal by a 1/4 cycle of the first clock signal.

In an embodiment, the first and second clock signals provided to the k+1^{th} stage may have phases shifted from the first and second clock signals provided to the k^{th} stage, respectively.

In an embodiment, the first clock signal may include a high voltage level and a low voltage level, and during a period of the high voltage level, a rising ripple may occur.

In an embodiment, the second clock signal may include the high voltage level and the low voltage level, and during a period of the high voltage level of the second clock signal, a falling ripple may occur.

In an embodiment, the logic circuit may include a first transistor which transmits the input signal to the second control node in response to the first clock signal, a second transistor which transmits the second clock signal to a first node in response to the signal of the second control node, a third transistor which transmits the low gate voltage to a second node in response to the first clock signal, a fourth transistor connected between the second node and a third node and always turned on, a fifth transistor which transmits the first clock signal to the second node in response to the signal of the second control node, sixth and seventh transistors which transmits the second clock signal to a fourth node in response to a signal of the third node and which are connected in series, an eighth transistor which transmits a signal of the fourth node to the first control node in response to the second clock signal, a first capacitor connected between a line which transmits the first clock signal and the first control node, a second capacitor connected between the third node and the fourth node, and a third capacitor connected between the first node and a gate of the second transistor.

In an embodiment, the output circuit may include a ninth transistor which outputs the first clock signal as the output signal in response to the signal of the first control node, and a tenth transistor which outputs the low gate voltage as the output signal in response to the signal of the second control node.

In an embodiment, the logic circuit may further include an eleventh transistor connected between the second control node and a gate of the tenth transistor and always turned on, a twelfth transistor which transmits the first clock signal to the second control node in response to a reset signal, a thirteenth transistor which transmits the low gate voltage to the first control node in response to the reset signal, and a fourteenth transistor which transmits the first clock signal to the first control node in response to the signal of the second control node.

An electronic apparatus according to embodiments include a processor which generate image data, and a display device which displays an image corresponding to the image data. The display device includes a display panel including pixels, and a gate driver which provides gate signals to the pixels and includes a k^{th} stage and a k+1^{th} stage, wherein k is a natural number greater than or equal to 1. Each of the k^{th} stage and the k+1^{th} stage includes a logic circuit which controls a signal of a first control node and a signal of a second control node based on an input signal, a first clock signal, and a second clock signal having a phase shifted from the first clock signal, and an output circuit which outputs a third clock signal or a low gate voltage as an output signal based on the signal of the first control node and the signal of the second control node. The third clock signal has the same phase as the first clock signal, while a line, which transmits the third clock signal, is electrically separated from a line, which transmits the first clock signal.

In an embodiment, the display panel may include an i^{th} pixel row and an i+1^{th} pixel row, wherein i is a natural number greater than or equal to 1. A gate signal output from the k^{th} stage may be commonly provided to the i^{th} pixel row and the i+1^{th} pixel row.

In the gate driver according to the embodiments, the third clock signal provided to the output circuit and the first clock signal provided to the logic circuit are electrically separated, or the second clock signal provided to the k^{th} stage is electrically separated from the first clock signal provided to the k+1^{th} stage, so that a falling ripple of a clock signal provided to the logic circuit may not affect a clock signal provided to the output circuit, and a falling ripple of an activation level of the gate signal may be prevented from occurring. Accordingly, the reliability of the gate signal may be effectively improved.

In the display device and the electronic apparatus according to the embodiments, the reliability of the gate signal is improved, so that a luminance difference between an odd pixel row and an even pixel row may not occur. Accordingly, the display quality of the display device may be effectively improved.

### BRIEF DESCRIPTION OF THE DRAWINGS

Illustrative, non-limiting embodiments will be more clearly understood from the following detailed description taken in conjunction with the accompanying drawings.
FIG. 1 is a block diagram illustrating a gate driver according to an embodiment.
FIG. 2 is a circuit diagram illustrating first and second stages of FIG. 1.
FIG. 3 is a waveform diagram illustrating signals of the first and second stages of FIG. 2.
FIG. 4 is a circuit diagram illustrating first and second stages according to a comparative example.
FIG. 5 is a waveform diagram illustrating a gate signal of FIG. 4.
FIG. 6 is a waveform diagram illustrating a gate signal of FIG. 2.
FIG. 7 is a block diagram illustrating a gate driver according to an embodiment.
FIG. 8 is a circuit diagram illustrating first and second stages of FIG. 7.
FIG. 9 is a waveform diagram illustrating signals of the first and second stages of FIG. 8.
FIG. 10 is a waveform diagram illustrating a gate signal of FIG. 8.
FIG. 11 is a block diagram illustrating a display device according to an embodiment.
FIG. 12 is a circuit diagram illustrating a pixel of FIG. 11.
FIG. 13 is a waveform diagram illustrating compensation gate signals and write gate signals according to a comparative example.
FIG. 14 is a waveform diagram illustrating compensation gate signals and write gate signals according to an embodiment.
FIG. 15 is a block diagram illustrating an electronic apparatus according to an embodiment.

### DETAILED DESCRIPTION

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third", "K^{th}", "K+1^{th}", "i^{th}", "i+1^{th}" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

It will be understood that when an element is referred to as being "connected to" another element, it can be directly connected to the other element or intervening elements may be present therebetween. In contrast, when an element is referred to as being "directly connected to" another element, there are no intervening elements present.

Hereinafter, a gate driver, a display device, and an electronic apparatus according to embodiments of the present disclosure will be described in more detail with reference to the accompanying drawings. The same or similar reference numerals will be used for the same elements in the accompanying drawings.

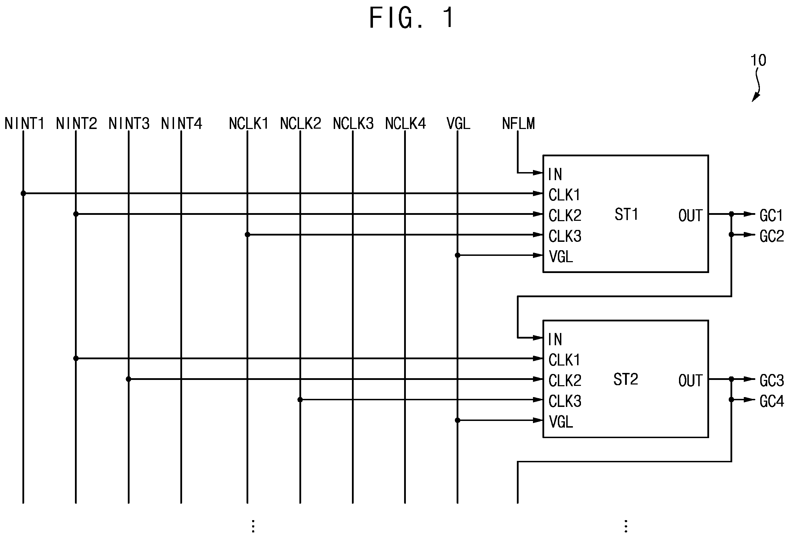

FIG. 1 is a block diagram illustrating a gate driver 10 according to an embodiment.

Referring to FIG. 1, the gate driver 10 may receive a first logic clock signal NINT1, a second logic clock signal NINT2, a third logic clock signal NINT3, a fourth logic clock signal NINT4, a first output clock signal NCLK1, a second output clock signal NCLK2, a third output clock signal NCLK3, a fourth output clock signal NCLK4, a low gate voltage VGL, and a gate start signal NFLM, and may output a plurality of gate signals GC1, GC2, GC3, GC4, ....

In an embodiment, the second logic clock signal NINT2 may have a phase shifted from the first logic clock signal NINT1 by 1/4 cycle of the first logic clock signal NINT1, the third logic clock signal NINT3 may have a phase shifted from the first logic clock signal NINT1 by 1/2 cycle of the first logic clock signal NINT1, and the fourth logic clock signal NINT4 may have a phase shifted from the first logic clock signal NINT1 by 3/4 cycle of the first logic clock signal NINT1.

The first output clock signal NCLK1 may have the same phase as the first logic clock signal NINT1, the second output clock signal NCLK2 may have the same phase as the second logic clock signal NINT2, the third output clock signal NCLK3 may have the same phase as the third logic clock signal NINT3, and the fourth output clock signal NCLK4 may have the same phase as the fourth logic clock signal NINT4.

In an embodiment, the second output clock signal NCLK2 may have a phase shifted by 1/4 cycle of the first output clock signal NCLK1, the third output clock signal NCLK3 may have a phase shifted by 1/2 cycle of the first output clock signal NCLK1, and the fourth output clock signal NCLK4 may have a phase shifted by 3/4 cycle of the first output clock signal NCLK1.

The low gate voltage VGL may have an activation level of a p-channel metal oxide semiconductor (PMOS) transistor, and may have a deactivation level of an n-channel metal oxide semiconductor (NMOS) transistor.

The gate driver 10 may include a plurality of stages ST1, ST2, ... including a k^{th} stage and a k+1^{th} stage, where k is a natural number greater than or equal to 1.

Hereinafter, the present disclosure will be described based on an embodiment in which k is 1. However, the present disclosure is not limited thereto, and may also be applied to embodiments in which k is 2 or more.

Each of the stages ST1, ST2, ... may receive an input signal IN, a first clock signal CLK1, a second clock signal CLK2, a third clock signal CLK3, and a low gate voltage VGL, and may output an output signal OUT.

A first stage ST1 may receive the gate start signal NFLM as the input signal IN, may receive the first logic clock signal NINT1 as the first clock signal CLK1, may receive the second logic clock signal NINT2 as the second clock signal CLK2, may receive the first output clock signal NCLK1 as the third clock signal CLK3, and may output a first gate signal GC1 and a second gate signal GC2 as the output signal OUT.

A second stage ST2 may receive the output signal OUT of the first stage ST1 as the input signal IN, may receive the second logic clock signal NINT2 as the first clock signal CLK1, may receive the third logic clock signal NINT3 as the second clock signal CLK2, may receive the second output clock signal NCLK2 as the third clock signal CLK3, and may output a third gate signal GC3 and a fourth gate signal GC4 as the output signal OUT.

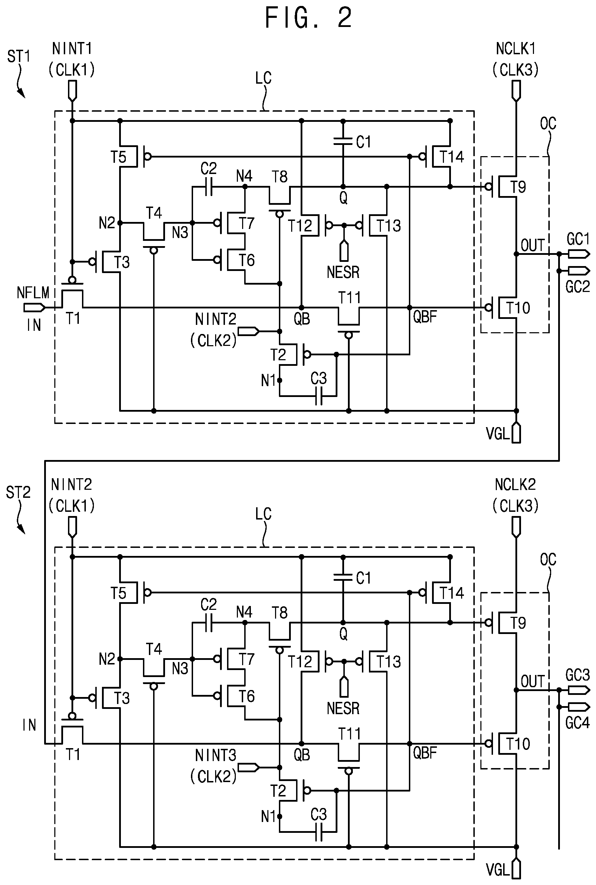

FIG. 2 is a circuit diagram illustrating the first and second stages ST1 and ST2 of FIG. 1.

Referring to FIGS. 1 and 2, each of the first and second stages ST1 and ST2 may include a logic circuit LC and an output circuit OC.

The logic circuit LC may control a signal of a first control node Q and a signal of a second control node QB based on the input signal IN, the first clock signal CLK1, and the second clock signal CLK2.

The output circuit OC may output the third clock signal CLK3 or the low gate voltage VGL as the output signal OUT based on the signal of the first control node Q and the signal of the second control node QB.

The logic circuit LC may include a first transistor T1, a second transistor T2, a third transistor T3, a fourth transistor T4, a fifth transistor T5, a sixth transistor T6, a seventh transistor T7, an eighth transistor T8, a first capacitor C1, a second capacitor C2, and a third capacitor C3. The output circuit OC may include a ninth transistor T9 and a tenth transistor T10. In an embodiment, the logic circuit LC may further include an eleventh transistor T11, a twelfth transistor T12, a thirteenth transistor T13, and a fourteenth transistor T14.

The first transistor T1 may transmit the input signal IN to the second control node QB in response to the first clock signal CLK1. The first transistor T1 may include a gate that receives the first clock signal CLK1, a first terminal that receives the input signal IN, and a second terminal connected to the second control node QB.

The second transistor T2 may transmit the second clock signal CLK2 to the first node N1 in response to the signal of the second control node QB. The second transistor T2 may include a gate connected to a third control node QBF, a first terminal that receives the second clock signal CLK2, and a second terminal connected to the first node N1.

The third transistor T3 may transmit the low gate voltage VGL to a second node N2 in response to the first clock signal CLK1. The third transistor T3 may include a gate that receives the first clock signal CLK1, a first terminal that receives the low gate voltage VGL, and a second terminal connected to the second node N2.

The fourth transistor T4 may be connected between the second node N2 and a third node N3, and may be always turned on. The fourth transistor T4 may include a gate that receives the low gate voltage VGL, a first terminal connected to the second node N2, and a second terminal connected to the third node N3.

The fifth transistor T5 may transmit the first clock signal CLK1 to the second node N2 in response to the signal of the second control node QB. The fifth transistor T5 may include a gate connected to the third control node QBF, a first terminal that receives the first clock signal CLK1, and a second terminal connected to the second node N2.

The sixth transistor T6 and the seventh transistor T7 may transmit the second clock signal CLK2 to a fourth node N4 in response to a signal of the third node N3, and may be connected in series. The sixth transistor T6 may include a gate connected to the third node N3, a first terminal that receives the second clock signal CLK2, and a second terminal. The seventh transistor T7 may include a gate connected to the third node N3, a first terminal connected to the second terminal of the sixth transistor T6, and a second terminal connected to the fourth node N4.

The eighth transistor T8 may transmit a signal of the fourth node N4 to the first control node Q in response to the second clock signal CLK2. The eighth transistor T8 may include a gate that receives the second clock signal CLK2, a first terminal connected to the fourth node N4, and a second terminal connected to the first control node Q.

The ninth transistor T9 may output the third clock signal CLK3 as the output signal OUT in response to the signal of the first control node Q. The ninth transistor T9 may include a gate connected to the first control node Q, a first terminal that receives the third clock signal CLK3, and a second terminal that outputs the output signal OUT.

The tenth transistor T10 may output the low gate voltage VGL as the output signal OUT in response to the signal of the second control node QB. The tenth transistor T10 may include a gate connected to the third control node QBF, a first terminal that receives the low gate voltage VGL, and a second terminal that outputs the output signal OUT.

The eleventh transistor T11 may be connected between the second control node QB and the third control node QBF, and may be always turned on. The eleventh transistor T11 may include a gate that receives the low gate voltage VGL, a first terminal connected to the second control node QB, and a second terminal connected to the third control node QBF.

The twelfth transistor T12 may transmit the first clock signal CLK1 to the second control node QB in response to a reset signal NESR. The twelfth transistor T12 may include a gate that receives the reset signal NESR, a first terminal that receives the first clock signal CLK1, and a second terminal connected to the second control node QB.

The thirteenth transistor T13 may transmit the low gate voltage VGL to the first control node Q in response to the reset signal NESR. The thirteenth transistor T13 may include a gate that receives the reset signal NESR, a first terminal that receives the low gate voltage VGL, and a second terminal connected to the first control node Q.

The fourteenth transistor T14 may transmit the first clock signal CLK1 to the first control node Q in response to the signal of the second control node QB. The fourteenth transistor T14 may include a gate connected to the third control node QBF, a first terminal that receives the first clock signal CLK1, and a second terminal connected to the first control node Q.

The transistors included in each of the first and second stages ST1 and ST2 may be PMOS transistors. In other words, each of the first transistor T1, the second transistor T2, the third transistor T3, the fourth transistor T4, the fifth transistor T5, the sixth transistor T6, the seventh transistor T7, the eighth transistor T8, the ninth transistor T9, the tenth transistor T10, the eleventh transistor T11, the twelfth transistor T12, the thirteenth transistor T13, and the fourteenth transistor T14 may be a PMOS transistor.

The first capacitor C1 may be connected between a line that transmits the first clock signal CLK1 and the first control node Q. The first capacitor C1 may include a first terminal that receives the first clock signal CLK1 and a second terminal connected to the first control node Q.

The second capacitor C2 may be connected between the third node N3 and the fourth node N4. The second capacitor C2 may include a first terminal connected to the third node N3 and a second terminal connected to the fourth node N4.

The third capacitor C3 may be connected between the first node N1 and the third control node QBF. The third capacitor C3 may include a first terminal connected to the first node N1 and a second terminal connected to the third control node QBF.

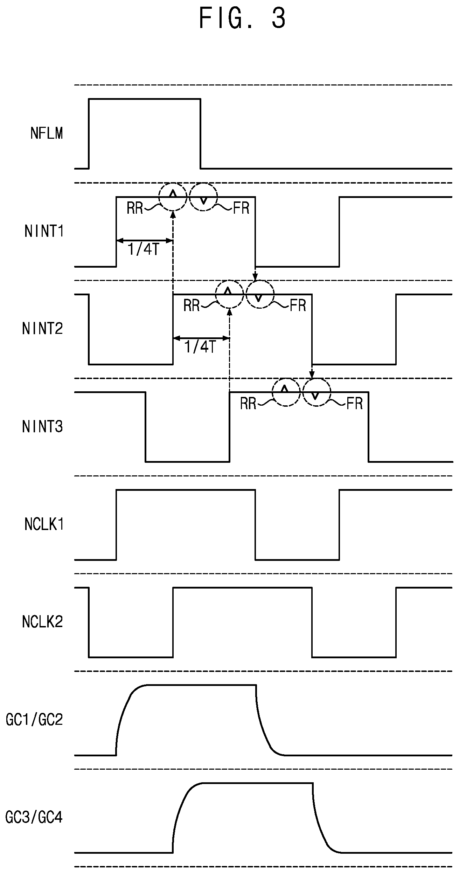

FIG. 3 is a waveform diagram illustrating signals of the first and second stages ST1 and ST2 of FIG. 2.

Referring to FIGS. 1 to 3, in each stage, the second clock signal CLK2 may have a phase shifted from the first clock signal CLK1. In an embodiment, the second clock signal CLK2 may have a phase shifted from the first clock signal CLK1 by 1/4 cycle 1/4T of the first clock signal CLK1.

In each stage, the third clock signal CLK3 may have the same phase as the first clock signal CLK1. In an embodiment, a line that transmits the third clock signal CLK3 may be electrically separated from the line that transmits the first clock signal CLK1 (not shown).

The third clock signal CLK3 (e.g., the second output clock signal NCLK2) provided to the k+1^{th} stage (e.g., the second stage ST2) may have the same phase as the second clock signal CLK2 (e.g., the second logic clock signal NINT2) provided to the k^{th} stage (e.g., the first stage ST1). In an embodiment, a line that transmits the third clock signal CLK3 provided to the k+1^{th} stage may be electrically separated from a line that transmits the second clock signal CLK2 provided to the k^{th} stage.

The first clock signal CLK1 (e.g., the second logic clock signal NINT2) provided to the k+1^{th} stage (e.g., the second stage ST2) may be electrically connected to the second clock signal CLK2 (e.g., the second logic clock signal NINT2) provided to the k^{th} stage (e.g., the first stage ST1). In other words, a line that transmits the first clock signal CLK1 provided to the k+1^{th} stage may be electrically connected to the line that transmits the second clock signal CLK2 provided to the k^{th} stage.

The first to third clock signals CLK1, CLK2, and CLK3 provided to the k+1^{th} stage (e.g., the second stage ST2) may have phases shifted from the first to third clock signals CLK1, CLK2, and CLK3 provided to the k^{th} stage (e.g., the first stage ST1). In an embodiment, the first clock signal CLK1 provided to the k+1^{th} stage may have a phase shifted by 1/4 cycle from the first clock signal CLK1 provided to the k^{th} stage, the second clock signal CLK2 provided to the k+1^{th} stage may have a phase shifted by 1/4 cycle from the second clock signal CLK2 provided to the k^{th} stage, and the third clock signal CLK3 provided to the k+1^{th} stage may have a phase shifted by 1/4 cycle from the third clock signal CLK3 provided to the k^{th} stage.

Each of the first clock signal CLK1 and the second clock signal CLK2 may include a rising ripple RR in which a high voltage level rises and a falling ripple FR in which the high voltage level falls. The rising ripple RR and the falling ripple FR may occur while each of the first clock signal CLK1 and the second clock signal CLK2 are in the high voltage level status. The first clock signal CLK1 may be applied to the third node N3 through the fourth transistor T4 and the fifth transistor T5 when the fourth transistor T4 and the fifth transistor T5 are turned on, and the second clock signal CLK2 may be applied to the fourth node N4 through the sixth transistor T6 and the seventh transistor T7 when the sixth transistor T6 and the seventh transistor T7 are turned on. The rising ripple RR may occur in the first clock signal CLK1 due to a coupling effect of the second capacitor C2 connected between the third node N3 and the fourth node N4 at a rising edge of the second clock signal CLK2. Further, the falling ripple FR may occur in the second clock signal CLK2 due to the coupling effect of the second capacitor C2 at a falling edge of the first clock signal CLK1. Since the first clock signal CLK1 provided to the k+1^{th} stage is electrically connected to the second clock signal CLK2 provided to the k^{th} stage, the falling ripple FR may occur in the first clock signal CLK1, and the rising ripple RR may occur in the second clock signal CLK2.

The third clock signal CLK3 may not include the rising ripple and the falling ripple. The third clock signal CLK3 (e.g., the second output clock signal NCLK2) provided to the k+1^{th} stage (e.g., the second stage ST2) may have the same phase as the first clock signal CLK1 (e.g., the second logic clock signal NINT2) provided to the k+1^{th} stage and the second clock signal CLK2 (e.g., the second logic clock signal NINT2) provided to the k^{th} stage (e.g., the first stage ST1), However, a line which transmits the third clock signal CLK3 may be electrically separated from a line which transmits the first clock signal CLK1 provided to the k+1^{th} stage and a line which transmits the second clock signal CLK2 provided to the k^{th} stage. Accordingly, unlike the first clock signal CLK1 and the second clock signal CLK2 each including the rising ripple RR and the falling ripple FR, the third clock signal CLK3 may not include the rising ripple and the falling ripple.

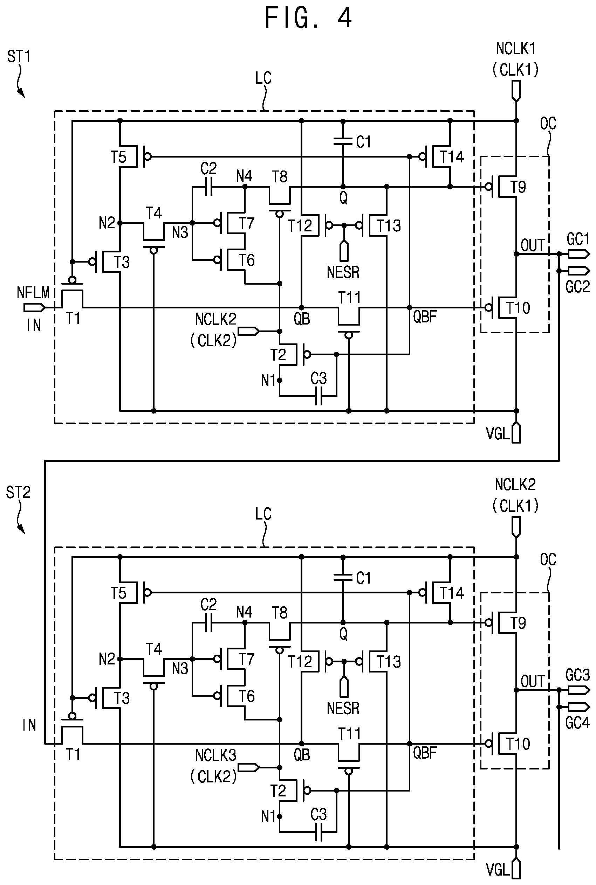

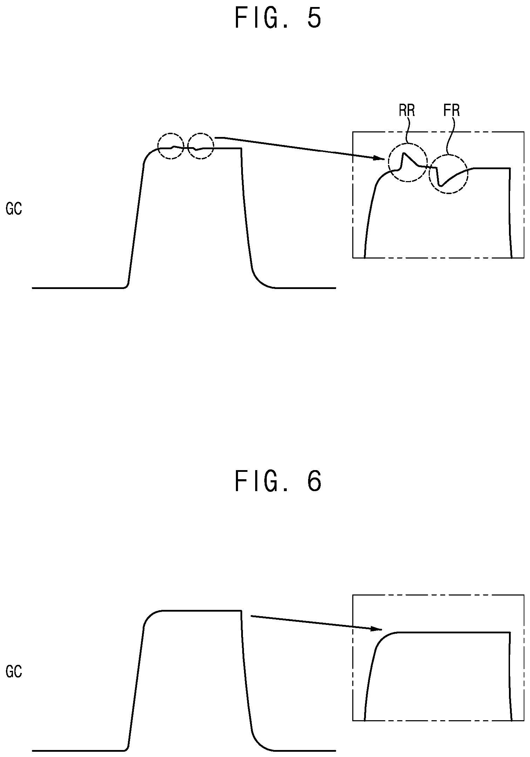

FIG. 4 is a circuit diagram illustrating first and second stages ST1 and ST2 according to a comparative example. FIG. 5 is a waveform diagram illustrating a gate signal GC of FIG. 4.

Referring to FIGS. 4 and 5, in the comparative example, a clock signal CLK1 provided to the logic circuit LC and a clock signal CLK1 provided to the output circuit OC may be electrically connected. As described above, each of the first clock signal CLK1 and the second clock signal CLK2 may include the rising ripple and the falling ripple due to the coupling effect of the second capacitor C2. The output circuit OC may output the first clock signal CLK1 as the gate signal GC when the ninth transistor T9 is turned on, and accordingly, the gate driver may output the gate signal GC having an activation level including the rising ripple RR and the falling ripple FR. When the activation level of the gate signal GC includes the falling ripple FR, the reliability of the gate signal GC may be degraded.

FIG. 6 is a waveform diagram illustrating the gate signal GC of FIG. 2.

Referring to FIGS. 2 and 6, in the present embodiment, the clock signal CLK1 provided to the logic circuit LC and the clock signal CLK3 provided to the output circuit OC may have the same phase and be electrically separated. As described above, even if each of the first clock signal CLK1 and the second clock signal CLK2 includes the rising ripple and the falling ripple due to the coupling effect of the second capacitor C2, a line which transmits the third clock signal CLK3 is electrically separated from a line which transmits the first clock signal CLK1, so that the third clock signal CLK3 may not include the rising ripple and the falling ripple. The output circuit OC may output the third clock signal CLK3 as the gate signal GC when the ninth transistor T9 is turned on, and accordingly, the gate driver may output the gate signal GC having an activation level that does not include the rising ripple and the falling ripple. When the activation level of the gate signal GC does not include the falling ripple, the reliability of the gate signal GC may be improved.

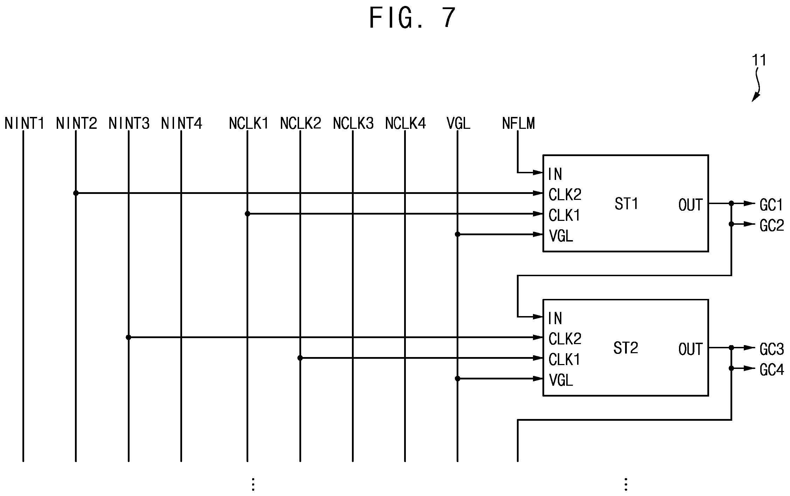

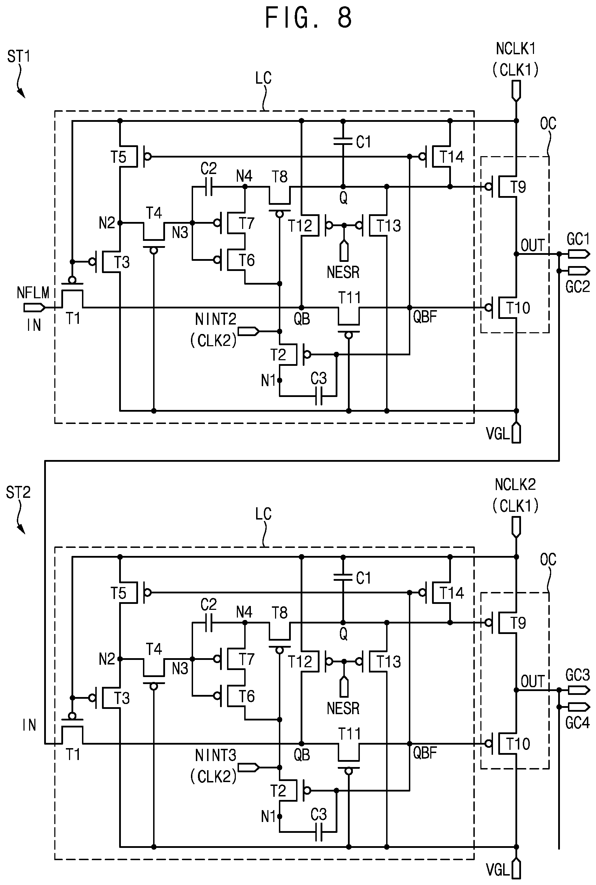

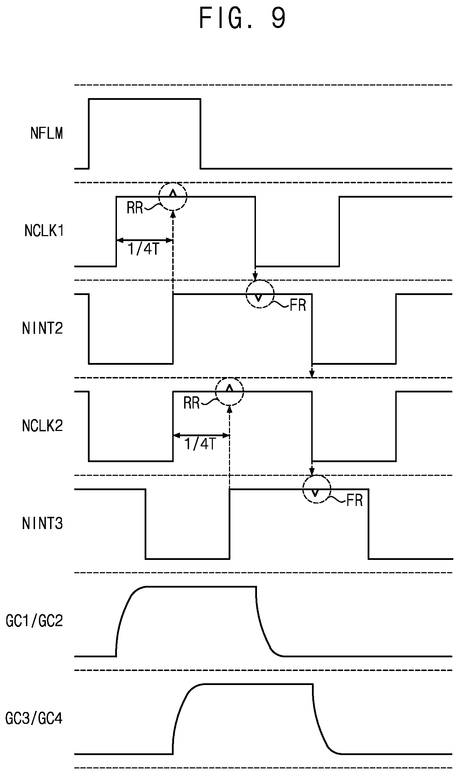

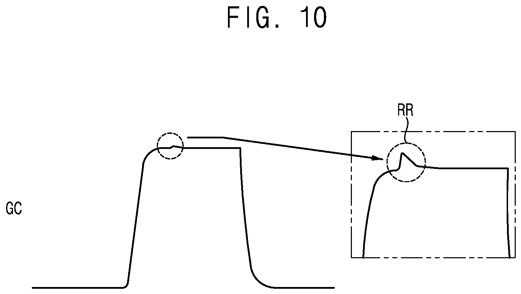

FIG. 7 is a block diagram illustrating a gate driver 11 according to an embodiment. FIG. 8 is a circuit diagram illustrating first and second stages ST1 and ST2 of FIG. 7. FIG. 9 is a waveform diagram illustrating signals of the first and second stages ST1 and ST2 of FIG. 8. FIG. 10 is a waveform diagram illustrating a gate signal GC of FIG. 8.

Descriptions of components of the gate driver 11 described with reference to FIGS. 7 to 10, which are substantially the same as or similar to those of the gate driver 10 described with reference to FIGS. 1 to 3 and 6, are omitted.

Referring to FIGS. 7 to 10, the gate driver 11 may receive a first logic clock signal NINT1, a second logic clock signal NINT2, a third logic clock signal NINT3, a fourth logic clock signal NINT4, a first output clock signal NCLK1, a second output clock signal NCLK2, a third output clock signal NCLK3, a fourth output clock signal NCLK4, a low gate voltage VGL, and a gate start signal NFLM, and may output a plurality of gate signals GC1, GC2, GC3, GC4, .... The gate driver 11 may include a plurality of stages ST1, ST2, ... including a k^{th} stage and a k+1^{th} stage.

Each of the stages ST1, ST2, ... may receive an input signal IN, a first clock signal CLK1, a second clock signal CLK2, and the low gate voltage VGL, and may output an output signal OUT.

A first stage ST1 may receive the gate start signal NFLM as the input signal IN, may receive the first output clock signal NCLK1 as the first clock signal CLK1, may receive the second logic clock signal NINT2 as the second clock signal CLK2, and may output a first gate signal GC1 and a second gate signal GC2 as the output signal OUT.

The second stage ST2 may receive the output signal OUT of the first stage ST1 as the input signal IN, may receive the second output clock signal NCLK2 as the first clock signal CLK1, may receive the third logic clock signal NINT3 as the second clock signal CLK2, and may output a third gate signal GC3 and a fourth gate signal GC4 as the output signal OUT.

Each of the first and second stages ST1 and ST2 may include a logic circuit LC and an output circuit OC.

The logic circuit LC may control a signal of a first control node Q and a signal of a second control node QB based on the input signal IN, the first clock signal CLK1, and the second clock signal CLK2.

The output circuit OC may output the first clock signal CLK1 or the low gate voltage VGL as the output signal OUT based on the signal of the first control node Q and the signal of the second control node QB.

The ninth transistor T9 may output the first clock signal CLK1 as the output signal OUT in response to the signal of the first control node Q. The ninth transistor T9 may include a gate connected to the first control node Q, a first terminal that receives the first clock signal CLK1, and a second terminal that outputs the output signal OUT.

In each stage, the second clock signal CLK2 may have a phase shifted from the first clock signal CLK1. In an embodiment, the second clock signal CLK2 may have a phase shifted by 1/4 cycle 1/4T of the first clock signal CLK1.

The first clock signal CLK1 (e.g., the second output clock signal NCLK2) provided to the k+1^{th} stage (e.g., the second stage ST2) may have the same phase as the second clock signal CLK2 (e.g., the second logic clock signal NINT2) provided to the k^{th} stage (e.g., the first stage ST1). In an embodiment , a line that transmits the first clock signal CLK1 provided to the k+1^{th} stage may be electrically separated from a line that transmits the second clock signal CLK2 provided to the k^{th} stage.

The first and second clock signals CLK1 and CLK2 provided to the k+1^{th} stage (e.g., the second stage ST2) may have phases shifted from the first and second clock signals CLK1 and CLK2 provided to the k^{th} stage (e.g., the first stage ST1). In an embodiment, the first clock signal CLK1 provided to the k+1^{th} stage may have a phase shifted from the first clock signal CLK1 provided to the k^{th} stage by 1/4 cycle, and the second clock signal CLK2 provided to the k+1^{th} stage may have a phase shifted from the second clock signal CLK2 provided to the k^{th} stage by 1/4 cycle.

The first clock signal CLK1 may include a rising ripple RR in which a high voltage level rises, and the second clock signal CLK2 may include a falling ripple FR in which the high voltage level falls. The rising ripple RR and the falling ripple FR may occur while the first clock signal CLK1 is in the high voltage level status. The first clock signal CLK1 may be applied to the third node N3 through the fourth transistor T4 and the fifth transistor T5 when the fourth transistor T4 and the fifth transistor T5 are turned on, and the second clock signal CLK2 may be applied to the fourth node N4 through the sixth transistor T6 and the seventh transistor T7 when the sixth transistor T6 and the seventh transistor T7 are turned on. The rising ripple RR may occur in the first clock signal CLK1 due to a coupling effect of the second capacitor C2 connected between the third node N3 and the fourth node N4 at a rising edge of the second clock signal CLK2. Further, the falling ripple FR may occur in the second clock signal CLK2 due to the coupling effect of the second capacitor C2 at a falling edge of the first clock signal CLK1. Since a line which transmits the first clock signal CLK1 provided to the k+1^{th} stage is electrically separated from a line which transmits the second clock signal CLK2 provided to the k^{th} stage, the falling ripple FR may not occur in the first clock signal CLK1, and the rising ripple RR may not occur in the second clock signal CLK2.

In the present embodiment, the clock signal CLK2 provided to the logic circuit LC of the k^{th} stage and the clock signal CLK1 provided to the output circuit OC of the k+1^{th} stage may have the same phase and be electrically separated. As described above, even if the second clock signal CLK2 includes the falling ripple due to the coupling effect of the second capacitor C2, since a line which transmits the first clock signal CLK1 provided to the k+1^{th} stage is electrically separated from a line which transmits the second clock signal CLK2 provided to the k^{th} stage, the first clock signal CLK1 may include only the rising ripple and not include the falling ripple. The output circuit OC may output the first clock signal CLK1 as the gate signal GC when the ninth transistor T9 is turned on, and accordingly, the gate driver may output the gate signal GC having an activation level that includes only the rising ripple RR and does not include the falling ripple. When the activation level of the gate signal GC does not include the falling ripple, the reliability of the gate signal GC may be improved.

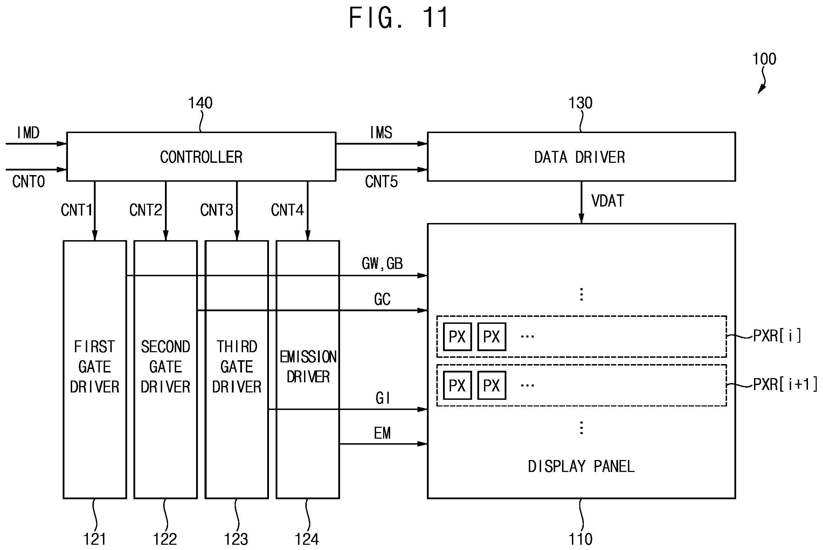

FIG. 11 is a block diagram illustrating a display device 100 according to an embodiment.

Referring to FIG. 11, the display device 100 may include a display panel 110, a first gate driver 121, a second gate driver 122, a third gate driver 123, an emission driver 124, a data driver 130, and a controller 140.

The display panel 110 may include pixels PX. The display panel 110 may include a plurality of pixel rows including an i^{th} pixel row PXR[i] and an i+1^{th} pixel row PXR[i+1], where i is a natural number greater than or equal to 1. For example, the i^{th} pixel row PXR[i] may be one of an odd pixel row and an even pixel row, and the i+1^{th} pixel row PXR[i+1] may be the other one of the odd pixel row and the even pixel row.

The first gate driver 121 may provide write gate signals GW and bypass gate signals GB to the pixels PX. The first gate driver 121 may generate the write gate signals GW and the bypass gate signals GB based on a first control signal CNT1. The first control signal CNT1 may include a write gate clock signal, a write gate start signal, a bypass gate clock signal, a bypass gate start signal, etc.

The second gate driver 122 may provide compensation gate signals GC to the pixels PX. The second gate driver 122 may correspond to the gate driver 10 of FIG. 1 and the gate driver 11 of FIG. 7. The second gate driver 122 may generate the compensation gate signals GC based on a second control signal CNT2. The second control signal CNT2 may include the first to fourth logic clock signals NINT1, NINT2, NINT3, and NINT4, the first to fourth output clock signals NCLK1, NCLK2, NCLK3, and NCLK4, and the compensation gate start signal NFLM of FIGS. 1 and 7.

The compensation gate signal GC output from the k^{th} stage of the second gate driver 122 may be commonly provided to the i^{th} pixel row PXR[i] and the i+1^{th} pixel row PXR[i+1]. For example, the first and second compensation gate signals GC1 and GC2 output from the first stage ST1 of FIGS. 1 and 7 may be commonly provided to a first pixel row and a second pixel row, respectively, and the third and fourth compensation gate signals GC3 and GC4 output from the second stage ST2 of FIGS. 1 and 7 may be commonly provided to a third pixel row and a fourth pixel row, respectively.

The third gate driver 123 may provide initialization gate signals GI to the pixels PX. The third gate driver 123 may generate the initialization gate signals GI based on a third control signal CNT3. In an embodiment, the third control signal CNT3 may include the first to fourth logic clock signals NINT1, NINT2, NINT3, and NINT4 and the first to fourth output clock signals NCLK1, NCLK2, NCLK3, and NCLK4 of FIGS. 1 and 7, and an initialization gate start signal.

The emission driver 124 may provide emission control signals EM to the pixels PX. The emission driver 124 may generate the emission control signals EM based on a fourth control signal CNT4. The fourth control signal CNT4 may include an emission clock signal, an emission start signal, etc.

The data driver 130 may provide data voltages VDAT to the pixels PX. The data driver 130 may generate the data voltages VDAT based on an image signal IMS and a fifth control signal CNT5. The data driver 130 may convert the digital format image signal IMS into the analog format data voltage VDAT. The fifth control signal CNT5 may include a data clock signal, a load signal, etc.

The controller 140 may control the operation (or driving) of the first gate driver 121, the operation (or driving) of the second gate driver 122, the operation (or driving) of the third gate driver 123, the operation (or driving) of the emission driver 124, and the operation (or driving) of the data driver 130. The controller 140 may provide the first control signal CNT1 to the first gate driver 121, may provide the second control signal CNT2 to the second gate driver 122, may provide the third control signal CNT3 to the third gate driver 123, may provide the fourth control signal CNT4 to the emission driver 124, and may provide the image signal IMS and the fifth control signal CNT5 to the data driver 130. The controller 140 may generate the image signal IMS based on image data IMD, and may generate the first control signal CNT1, the second control signal CNT2, the third control signal CNT3, the fourth control signal CNT4, and the fifth control signal CNT5 based on a controller control signal CNT0. The controller control signal CNT0 may include a horizontal synchronization signal, a vertical synchronization signal, a master clock signal, a data enable signal, etc.

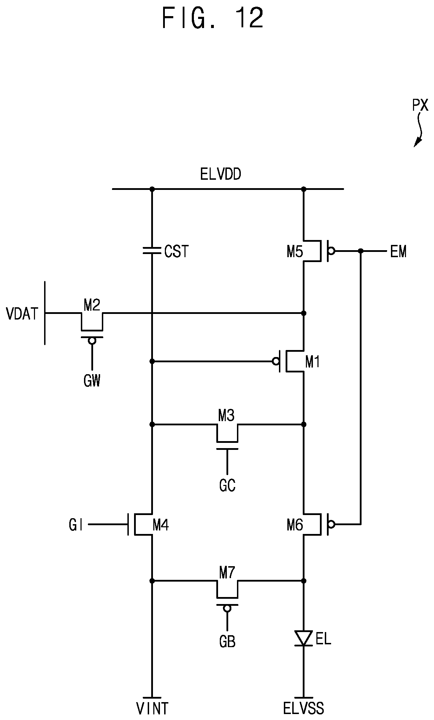

FIG. 12 is a circuit diagram illustrating the pixel PX of FIG. 11.

Referring to FIG. 12, the pixel PX may receive the write gate signal GW, the compensation gate signal GC, the initialization gate signal GI, the bypass gate signal GB, the emission control signal EM, the data voltage VDAT, an initialization voltage VINT, a first power voltage ELVDD, and a second power voltage ELVSS. In an embodiment, a voltage level of the first power voltage ELVDD may be higher than a voltage level of the second power voltage ELVSS.

The pixel PX may include a light-emitting element EL, a driving transistor M1, a write transistor M2, a compensation transistor M3, an initialization transistor M4, a first emission control transistor M5, a second emission control transistor M6, a bypass transistor M7, and a storage capacitor CST.

The light-emitting element EL may be connected between a line that transmits the first power voltage ELVDD and a line that transmits the second power voltage ELVSS. The light-emitting element EL may include an anode and a cathode that receives the second power voltage ELVSS. The light-emitting element EL may emit light with a luminance corresponding to a driving current.

In an embodiment, the light-emitting element EL may be an organic light-emitting diode, an inorganic light-emitting diode, a micro light-emitting diode, a nano light-emitting diode, a quantum dot light-emitting diode, etc.

The driving transistor M1 may generate the driving current flowing through the light-emitting element EL. The driving transistor M1 may include a gate, a first terminal, and a second terminal. The driving transistor M1 may generate the driving current corresponding to a voltage difference between the gate and the first terminal.

The write transistor M2 may transmit the data voltage VDAT to the first terminal of the driving transistor M1 in response to the write gate signal GW. The write transistor M2 may include a gate that receives the write gate signal GW, a first terminal that receives the data voltage VDAT, and a second terminal connected to the first terminal of the driving transistor M1.

The compensation transistor M3 may connect the gate of the driving transistor M1 to the second terminal of the driving transistor M1 in response to the compensation gate signal GC. The compensation transistor M3 may include a gate that receives the compensation gate signal GC, a first terminal connected to the second terminal of the driving transistor M1, and a second terminal connected to the gate of the driving transistor M1.

The initialization transistor M4 may transmit the initialization voltage VINT to the gate of the driving transistor M1 in response to the initialization gate signal GI. The initialization transistor M4 may include a gate that receives the initialization gate signal GI, a first terminal that receives the initialization voltage VINT, and a second terminal connected to the gate of the driving transistor M1.

The first emission control transistor M5 may transmit the first power voltage ELVDD to the first terminal of the driving transistor M1 in response to the emission control signal EM. The first emission control transistor M5 may include a gate that receives the emission control signal EM, a first terminal that receives the first power voltage ELVDD, and a second terminal connected to the first terminal of the driving transistor M1.

The second emission control transistor M6 may connect the second terminal of the driving transistor M1 to the anode of the light-emitting element EL in response to the emission control signal EM. The second emission control transistor M6 may include a gate that receives the emission control signal EM, a first terminal connected to the second terminal of the driving transistor M1, and a second terminal connected to the anode of the light-emitting element EL.

The bypass transistor M7 may transmit the initialization voltage VINT to the anode of the light-emitting element EL in response to the bypass gate signal GB. The bypass transistor M7 may include a gate that receives the bypass gate signal GB, a first terminal that receives the initialization voltage VINT, and a second terminal connected to the anode of the light-emitting element EL.

In an embodiment, each of the driving transistor M1, the writing transistor M2, the first emission control transistor M5, the second emission control transistor M6, and the bypass transistor M7 may be a PMOS transistor, and each of the compensation transistor M3 and the initialization transistor M4 may be an NMOS transistor.

The storage capacitor CST may be connected between the line that transmits the first power voltage ELVDD and the gate of the driving transistor M1. The storage capacitor CST may include a first terminal that receives the first power supply voltage ELVDD and a second terminal connected to the gate of the driving transistor M1.

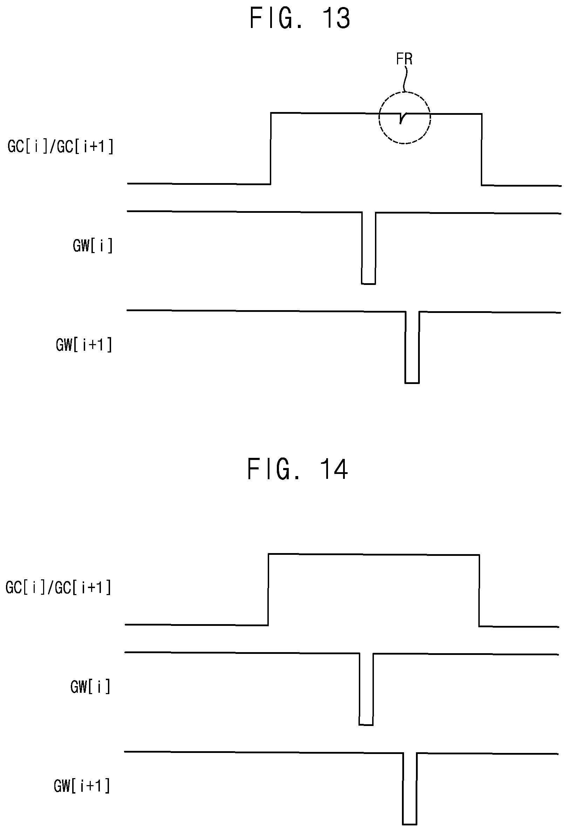

FIG. 13 is a waveform diagram illustrating compensation gate signals GC[i] and GC[i+1] and write gate signals GW[i] and GW[i+1] according to a comparative example. FIG. 14 is a waveform diagram illustrating compensation gate signals GC[i] and GC[i+1] and write gate signals GW[i] and GW[i+1] according to an embodiment.

Referring to FIGS. 12 to 14, pulses of the write gate signals GW[i] and GW[i+1] having a low voltage level, which is an activation level, may be positioned within a period in which the compensation gate signal GC[i]/GC[i+1] has a high voltage level, which is an activation level. The data voltage VDAT in which a threshold voltage of the driving transistor M1 is compensated may be written to the pixel PX of the i^{th} pixel row PXR[i] when the pulse of the i^{th} write gate signal GW[i] is applied to the i^{th} pixel row PXR[i], and the data voltage VDAT in which the threshold voltage of the driving transistor M1 is compensated may be written to the pixel PX of the i+1^{th} pixel row PXR[i+1] when the pulse of the i+1^{th} write gate signal GW[i+1] is applied to the i+1^{th} pixel row PXR[i+1].

A parasitic capacitance may be formed between a line that transmits the compensation gate signal GC and a line that transmits the write gate signal GW, and a change in the activation level of the compensation gate signal GC in a period in which the pulse of the write gate signal GW is applied may affect a level of the data voltage VDAT written to the pixel PX in response to the pulse of the write gate signal GW due to coupling between the line that transmits the compensation gate signal GC and the line that transmits the write gate signal GW. For example, the activation level of the pulse of the write gate signal GW may increase when the activation level of the compensation gate signal GC decreases in a period in which the pulse of the write gate signal GW is applied, and accordingly, the data voltage VDAT written to the pixel PX in response to the pulse of the write gate signal GW may change.

In the comparative example, as illustrated in FIG. 13, when the activation level of the compensation gate signal GC[i]/GC[i+1] includes a falling ripple FR that overlaps the pulse of the i+1^{th} write gate signal GW[i+1], the data voltage VDAT written to the i+1^{th} pixel row PXR[i+1] may change by the falling ripple FR of the compensation gate signal GC[i]/GC[i+1]. In this case, even if the i^{th} pixel row PXR[i] and the i+1^{th} pixel row PXR[i+1] display the same grayscale, the data voltage VDAT written to the i^{th} pixel row PXR[i] and the data voltage VDAT written to the i+1^{th} pixel row PXR[i+1] may be different, and accordingly, a luminance difference may occur between the i^{th} pixel row PXR[i] and the i+1^{th} pixel row PXR[i+1]. Accordingly, the image quality of the display device 100 may be degraded.

In the present embodiment, as illustrated in FIG. 14, when the activation level of the compensation gate signal GC[i]/GC[i+1] does not include the falling ripple that overlaps the pulse of the i+1^{th} write gate signal GW[i+1], the data voltage VDAT written to the i+1^{th} pixel row PXR[i+1] may not change. In this case, when the i^{th} pixel row PXR[i] and the i+1^{th} pixel row PXR[i+1] display the same grayscale, the data voltage VDAT written to the i^{th} pixel row PXR[i] and the data voltage VDAT written to the i+1^{th} pixel row PXR[i+1] may be the same, and accordingly, a luminance difference may not occur between the i^{th} pixel row PXR[i] and the i+1^{th} pixel row PXR[i+1]. Accordingly, the image quality of the display device 100 may be effectively improved.

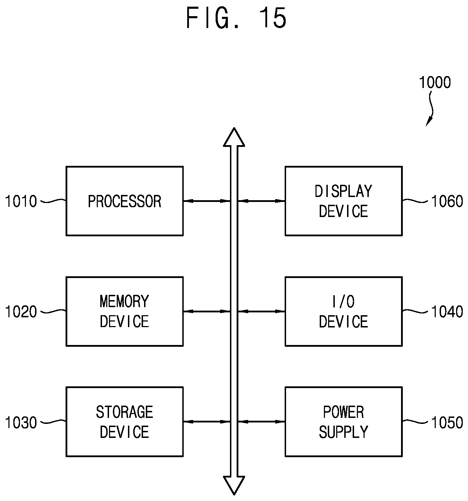

FIG. 15 is a block diagram illustrating an electronic apparatus according to an embodiment.

Referring to FIG. 15, the electronic apparatus 1000 may include a processor 1010, a memory device 1020, a storage device 1030, an input/output (I/O) device 1040, a power supply 1050, and a display device 1060. The electronic apparatus 1000 may further include a plurality of ports capable of communicating with a video card, a sound card, a memory card, a USB device, and the like, or communicating with other systems.

The processor 1010 may perform specific calculations or tasks. In an embodiment, the processor 1010 may be a microprocessor, a central processing unit (CPU), or the like. The processor 1010 may be connected to other components through an address bus, a control bus, a data bus, and the like. In an embodiment, the processor 1010 may also be connected to an expansion bus such as a peripheral component interconnect (PCI) bus.

The processor 1010 may control the display device 1060. In an embodiment, the processor 1010 may provide the image data IMD of FIG. 11 and the controller control signal CNT0 of FIG. 11 to the display device 1060.

The memory device 1020 may store data required for an operation of the electronic apparatus 1000. For example, the memory device 1020 may include: a nonvolatile memory device such as an erasable programmable read-only memory (EPROM), an electrically erasable programmable read-only memory (EEPROM), a flash memory, a phase change random access memory (PRAM), a resistance random access memory (RRAM), a nano floating gate memory (NFGM), a polymer random access memory (PoRAM), a magnetic random access memory (MRAM), or a ferroelectric random access memory (FRAM); and/or a volatile memory device such as a dynamic random access memory (DRAM), a static random access memory (SRAM), or a mobile DRAM.

The storage device 1030 may include a solid state drive (SSD), a hard disk drive (HDD), a CD-ROM, and the like. The I/O device 1040 may include: an input device such as a keyboard, a keypad, a touch pad, a touch screen, or a mouse; and an output device such as a speaker or a printer. The power supply 1050 may supply a power required for the operation of the electronic apparatus 1000. The display device 1060 may be connected to other components through the buses or other communication links. The display device 1060 may correspond to the display device 100 of FIG. 11.

The display device according to the embodiments may be applied to a display device included in a computer, a notebook, a mobile phone, a smart phone, a smart pad, a smart watch, a PMP, a PDA, an MP3 player, or the like.

Although the gate driver, the display device, and the electronic apparatus according to the embodiments have been described with reference to the drawings, the illustrated embodiments are examples, and may be modified and changed by a person having ordinary knowledge in the relevant technical field without departing from the scope described in the following claims.

## Claims

1. A gate driver (10) for a display device, the gate driver comprising a k^{th} stage and a k+1^{th} stage, wherein k is a natural number greater than or equal to 1,
each of the k^{th} stage and the k+1^{th} stage comprising:
a logic circuit (LC) which controls a signal of a first control node and a signal of a second control node based on an input signal, a first clock signal, and a second clock signal having a phase shifted from the first clock signal; and
an output circuit (OC) which outputs a third clock signal or a low gate voltage as an output signal based on the signal of the first control node and the signal of the second control node,
wherein the third clock signal has a same phase as the first clock signal, while a line, which transmits the third clock signal, is electrically separated from a line, which transmits the first clock signal.

2. The gate driver (10) of claim 1, wherein the third clock signal provided to the k+1^{th} stage has a same phase as the second clock signal provided to the k^{th} stage, while a line, which transmits the second clock signal provided to the k^{th} stage, is electrically separated from a line, which transmits the second clock signal provided to the k^{th} stage.

3. The gate driver (10) of claim 1 or 2, wherein a line, which transmits the first clock signal provided to the k+1^{th} stage is electrically connected to a line, which transmits the second clock signal provided to the k^{th} stage.

4. The gate driver (10) of any of the preceding claims, wherein the second clock signal has a phase shifted from the first clock signal by a 1/4 cycle of the first clock signal.

5. The gate driver (10) of any of the preceding claims, wherein the first to third clock signals provided to the k+1^{th} stage have phases shifted from the first to third clock signals provided to the k^{th} stage, respectively.

6. The gate driver (10) of any of the preceding claims, wherein each of the first clock signal and the second clock signal includes a high voltage level and a low voltage level, and during a period of the high voltage level, a rising ripple and a falling ripple occur.

7. The gate driver (10) of claim 6, wherein the third clock signal does not include the rising ripple and the falling ripple.

8. The gate driver (10) of any of the preceding claims, wherein the logic circuit (LC) comprises:
a first transistor (T1) which transmits the input signal to the second control node in response to the first clock signal;
a second transistor (T2) which transmits the second clock signal to a first node in response to the signal of the second control node;
a third transistor (T3) which transmits the low gate voltage to a second node in response to the first clock signal;
a fourth transistor (T4) connected between the second node and a third node and always turned on;
a fifth transistor (T5) which transmits the first clock signal to the second node in response to the signal of the second control node;
sixth and seventh transistors (T6, T7) which transmit the second clock signal to a fourth node in response to a signal of the third node and which are connected in series;
an eighth transistor (T8) which transmits a signal of the fourth node to the first control node in response to the second clock signal;
a first capacitor (C1) connected between a line which transmits the first clock signal and the first control node;
a second capacitor (C2) connected between the third node and the fourth node; and
a third capacitor (C3) connected between the first node and a gate of the second transistor.

9. The gate driver (10) of claim 8, wherein the output circuit (OC) comprises:
a ninth transistor (T9) which outputs the third clock signal as the output signal in response to the signal of the first control node; and
a tenth transistor (T10) which outputs the low gate voltage as the output signal in response to the signal of the second control node.

10. The gate driver (10) of claim 8 or 9, wherein the logic circuit (LC) further comprises:
an eleventh transistor (T11) connected between the second control node and a gate of the tenth transistor and always turned on;
a twelfth transistor (T12) which transmits the first clock signal to the second control node in response to a reset signal;
a thirteenth transistor (T13) which transmits the low gate voltage to the first control node in response to the reset signal; and
a fourteenth transistor (T14) which transmits the first clock signal to the first control node in response to the signal of the second control node.

11. A gate driver (11) for a display device, the gate driver comprising a k^{th} stage and a k+1^{th} stage, wherein k is a natural number greater than or equal to 1, each of the k^{th} stage and the k+1^{th} stage comprising:
a logic circuit (LC) which controls a signal of a first control node and a signal of a second control node based on an input signal, a first clock signal, and a second clock signal having a phase shifted from the first clock signal; and
an output circuit (OC) which outputs the first clock signal or a low gate voltage as an output signal based on the signal of the first control node and the signal of the second control node,
wherein the first clock signal provided to the k+1^{th} stage has a same phase as the second clock signal provided to the k^{th} stage, while a line, which transmits the first clock signal provided to the k+1^{th} stage is electrically separated from a line, which transmits the second clock signal provided to the k^{th} stage.

12. The gate driver (11) of claim 11, wherein the second clock signal has a phase shifted from the first clock signal by a 1/4 cycle of the first clock signal.

13. The gate driver (11) of claim 11 or 12, wherein the first and second clock signals provided to the k+1^{th} stage have phases shifted from the first and second clock signals provided to the k^{th} stage, respectively.

14. An electronic apparatus (1000), comprising:
a processor (1010) which generate image data; and
a display device (100, 1060) which displays an image corresponding to the image data, the display device (100, 1060) comprising:
a display panel (110) including pixels; and
a gate driver (10, 11) of any of the preceding claims.

15. The electronic apparatus (1000) of claim 14, wherein the display panel (110) includes an i^{th} pixel row and an i+1^{th} pixel row, wherein i is a natural number greater than or equal to 1, and
wherein a gate signal output from the k^{th} stage is commonly provided to the i^{th} pixel row and the i+1^{th} pixel row.
